# EUROPEAN PATENT APPLICATION

(11) **EP 2 690 195 A1**
(43) Date of publication of application: **29.01.2014**
(21) Application number: 12760790.1
(22) Date of filing: 22.03.2012
(51) Int. Cl.: C23C 24/04, B32B 15/01, C22F 1/04, C22F 1/08, C23C 28/02, H01B 5/02, H01B 13/00

(54) **LAMINATE, CONDUCTIVE MATERIAL, AND PROCESS FOR PRODUCING LAMINATE**

(30) Priority: 23.03.2011 JP 2011064493
(71) Applicant: NHK Spring Co., Ltd., Kanagawa 236-0004 (JP)
(72) Inventor: HIRANO, Satoshi, Isehara-shi Kanagawa 259-1126 (JP); YAMAUCHI, Yuichiro, Yokohama-shi Kanagawa 236-0004 (JP); AKABAYASHI, Masaru, Yokohama-shi Kanagawa 236-0004 (JP); SAITO, Shinji, Yokohama-shi Kanagawa 236-0004 (JP); HANAMACHI, Toshihiko, Isehara-shi Kanagawa 259-1126 (JP)
(74) Representative: HOFFMANN EITLE
(86) International application number: PCT/JP2012/057375
(87) International publication number: WO 2012/128327

(57) **Abstract**

A lamination having a high interface strength, in which a copper film is laminated on an aluminum substrate, or a lamination in which an aluminum film is laminated on a copper substrate, are manufactured by a cold spray method. A lamination 10 of the present invention includes: a substrate 1 formed of aluminum or aluminum alloy; an intermediate layer 2 formed of any one metal or nonmetal selected from the group consisting of silver, gold, chromium, iron, germanium, manganese, nickel, silicon, and zinc, or an alloy containing the any one metal, on a surface of the substrate 1; and a film layer 3 formed by accelerating powder material of copper or copper alloy together with gas heated to a temperature lower than a melting point of the powder material and spraying and depositing a solid-phase powder material onto a surface of the intermediate layer 2.

## Description

### Field

The present invention relates to a lamination, a conductive material, and a method for manufacturing a lamination.

### Background

Recently, as a kind of spray method, attention is being attracted to a cold spray method that sprays material powder onto a substrate at high temperature at high speed to deposit and coat the material powder on the substrate. The cold spray method forms a film on a surface of a substrate by colliding a solid-phase material for the film against the substrate after spraying the same from a convergent-divergent (Laval) nozzle together with inert gat heated to a melting point or a softening point or less of material powder, thus making it possible to obtain a metal film having no phase transformation and suppressed oxidation.

Conventionally, as a cold spray method, a technology for spraying material powder after controlling a temperature of a substrate to a predetermined temperature (see, for example, Patent Literature 1), or a technology for forming a metal film by controlling a temperature of a substrate and/or inert gas (see, for example, Patent Literature 2) is disclosed.

### Citation List

### Patent Literature

Patent Literature 1: Japanese Laid-open Patent Publication No. 2008-302317
Patent Literature 2: Japanese Laid-open Patent Publication No. 2008-127676

### Summary

### Technical Problem

However, when a lamination having a metal film formed by the cold spray method is used in a conductive material or the like, a lamination having high conductivity is suitably used. However, since the lamination laminated by the cold spray method does not have desired conductivity, it needs to be annealed.

In the case of annealing copper, the copper is annealed at about 300°C to about 600°C in general. However, in the case of a lamination having a copper film laminated on an aluminum substrate, an annealing temperature cannot be increased up to 600°C. In general, as the annealing temperature increases, improvement in the workability and conductivity of the copper film can be expected. However, when a copper/aluminum lamination is annealed at a temperature of 250°C or higher, there is a problem that an intermetallic compound is created at an interface of copper and aluminum, thus reducing the strength of the interface and increasing the resistance of the lamination.

In consideration of this, an object of the present invention is to suppress the creation of an intermetallic compound at an interface of a lamination, in which a copper film is laminated on an aluminum substrate or an aluminum film is laminated on a copper substrate by using a cold spray method, and thus prevent a degradation in the strength of the interface of the lamination, and to provide a conductive material using the lamination and a method for manufacturing the lamination.

### Solution to Problem

To solve the problem described above and achieve the object, a lamination according to the present invention includes: a substrate formed of aluminum or aluminum alloy; an intermediate layer formed of any one metal or nonmetal selected from the group consisting of silver, gold, chromium, iron, germanium, manganese, nickel, silicon, and zinc, or an alloy containing the any one metal, on a surface of the substrate; and a film layer formed by accelerating powder material of copper or copper alloy together with gas heated to a temperature lower than a melting point of the powder material and spraying and depositing a solid-phase powder material onto a surface of the intermediate layer.

Moreover, a lamination according to the present invention includes: a substrate formed of copper or copper alloy; an intermediate layer formed of any one metal or nonmetal selected from the group consisting of silver, gold, chromium, iron, germanium, manganese, nickel, silicon, and zinc, or an alloy containing the any one metal, on a surface of the substrate; and a film layer formed by accelerating powder material of aluminum or aluminum alloy together with gas heated to a temperature lower than a melting point of the powder material and spraying and depositing a solid-phase powder material onto a surface of the intermediate layer.

Moreover, according to the lamination of the present invention, in the invention, the lamination is heated at a predetermined temperature after the formation of the film layer.

Moreover, according to the lamination of the present invention, in the invention, the heating temperature is 300°C to 500°C.

Moreover, according to the lamination of the present invention, in the invention, the intermediate layer is a multi-layered lamination including an element.

Moreover, according to the lamination of the present invention, in the invention, the intermediate layer has a thickness of 0.2 µm to 20 µm.

Moreover, according to the lamination of the present invention, in the invention, the intermediate layer is formed by spraying, cold spraying, plating, sputtering, or CVD.

Moreover, a conductive material according to the present invention includes any one of the above-described laminations.

Moreover, a method for manufacturing a lamination according to the present invention includes the steps of: forming an intermediate layer, which is formed of any one metal or nonmetal selected from the group consisting of silver, gold, chromium, iron, germanium, manganese, nickel, silicon, and zinc, or an alloy containing the any one metal, on a surface of a substrate formed of aluminum or aluminum alloy; and forming a film layer by accelerating powder material of copper or copper alloy together with gas heated to a temperature lower than a melting point of the powder material and spraying and depositing a solid-phase powder material onto a surface of the intermediate layer.

Moreover, a method for manufacturing a lamination according to the present invention includes the steps of: forming an intermediate layer, which is formed of any one metal or nonmetal selected from the group consisting of silver, gold, chromium, iron, germanium, manganese, nickel, silicon, and zinc, or an alloy containing the any one metal, on a surface of a substrate formed of copper or copper alloy; and forming a film layer by accelerating powder material of aluminum or aluminum alloy together with gas heated to a temperature lower than a melting point of the powder material and spraying and depositing a solid-phase powder material onto a surface of the intermediate layer.

Moreover, the method for manufacturing a lamination according to the present invention, includes the step of an annealing process for heating the lamination at a predetermined temperature after the step of forming a film layer.

### Advantageous Effects of Invention

The lamination according to the present invention can achieve the effect of suppressing the creation of an intermetallic compound of aluminum and copper, which may be caused when the lamination is annealed, preventing a degradation in the strength of an interface thereof, and improving the conductivity of the lamination, by providing an intermediate layer formed of a predetermined metal or the like between the aluminum substrate and the copper film or between the copper substrate and the aluminum film. Moreover, the lamination of the present invention can achieve the effect of maintaining the strength of the interface of the lamination since the creation of an intermetallic compound under a long-term use environment can be suppressed even when annealing is not performed.

### Brief Description of Drawings

FIG. 1 is a schematic diagram illustrating a configuration of a lamination according to an embodiment of the present invention.
FIG. 2 is a schematic diagram illustrating an outline of a cold spray device used to manufacture a lamination according to the embodiment of the present invention.
FIG. 3 is a diagram illustrating a sectional structure of a lamination according to the embodiment of the present invention.
FIG. 4 is a diagram illustrating a sectional structure of a lamination according to the embodiment of the present invention.
FIG. 5 is a diagram illustrating a sectional structure of a lamination according to a comparative example.
FIG. 6 is a diagram illustrating a sectional structure of a lamination according to the present invention after a long-tem retention test.
FIG. 7 is a diagram illustrating a sectional structure of a lamination according to the comparative example after a long-tem retention test.

### Description of Embodiments

Hereinafter, embodiments of the present invention will be described in detail with reference to the drawings. In addition, the present invention is not limited by these embodiments. Moreover, the respective drawings referred to in the following description merely schematically illustrate shapes, sizes, and positional relations to the extent of being able to understand the contents of the present invention. That is, the present invention is not limited to the shapes, sizes and positional relations illustrated in the respective drawings.

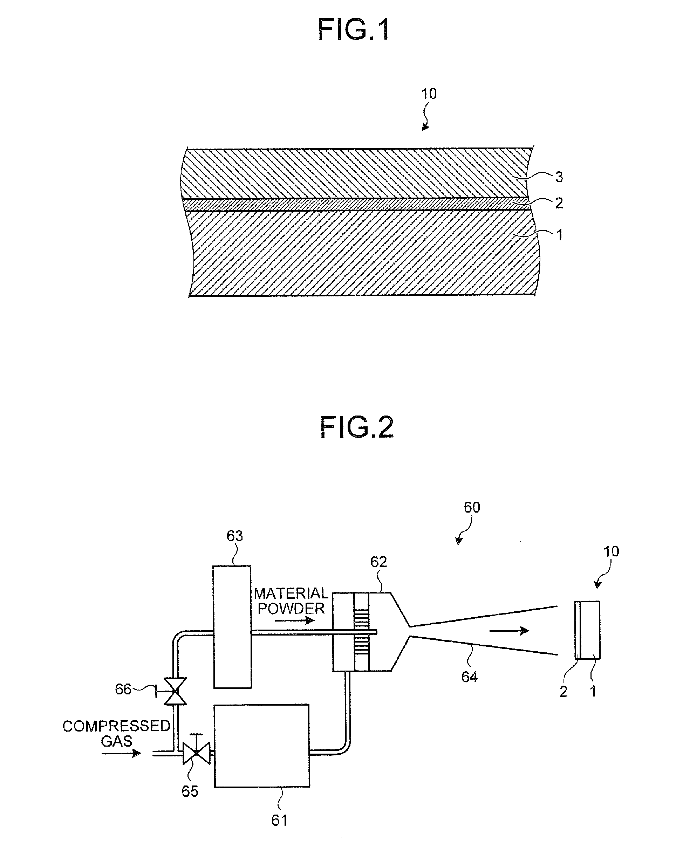

First, a lamination according to an embodiment of the present invention will be described in detail with reference to the drawings. FIG. 1 is a schematic diagram illustrating a configuration of a lamination according to an embodiment of the present invention.

A lamination 10 includes a substrate 1, an intermediate layer 2 formed on a surface of the substrate 1, and a metal film 3 laminated on the intermediate layer 2 by a cold spray method which will be described later.

The substrate 1 is substantially plate-shaped, and is formed of aluminum or aluminum alloy.

The intermediate layer 2 is a film that is formed on the surface of the substrate 1 by spraying, cold spraying, plating, sputtering, or CVD. The intermediate layer 2 is formed of any one metal or nonmetal selected from the group consisting of silver, gold, chromium, iron, germanium, manganese, nickel, silicon, and zinc, or an alloy containing the any one metal. The intermediate layer 2 preferably has a thickness of 0.2 µm to 20 µm. This is because, when the thickness of the intermediate layer 2 is smaller than 0.2 µm, the effect of suppressing the creation of an intermetallic compound between the substrate 1 and the metal film 3, which will be described later, is reduced; and when the thickness of the intermediate layer 2 is greater than 20 µm, it may affect the conductivity or the like of the lamination 10. Moreover, the intermediate layer 2 may be not only a one-layered intermediate layer formed of the any one metal or nonmetal or an alloy containing the any one metal, but also a two or more-layered, multi-layered intermediate layer 2 formed of the any one metal or nonmetal or an alloy containing the any one metal.

The metal film 3 is a copper film or a copper alloy film that is formed on the surface of the substrate 1 with the intermediate layer 2 interposed therebetween. The metal film 3 is formed by accelerating a copper or copper alloy powder material by a cold spray device, which will be described later, together with gas heated to a temperature lower than a melting point of the powder material, and spraying and depositing the solid-phase powder material onto a surface opposite to a surface of the intermediate layer 2 contacting the substrate 1.

Next, formation of the metal film 3 will be described with reference to FIG. 2. FIG. 2 is a schematic diagram illustrating an outline of a cold spray device used to form the metal film 3.

A cold spray device 60 includes a gas heater 61 that heats compressed gas, a powder supply device 63 that accommodates a powder material sprayed onto the substrate and supplies the powder material to a spray gun 62, and a gas nozzle 64 that sprays material powder mixed with the heated compressed gas by the spray gun 62 onto the substrate 1.

Helium, nitrogen, air, or the like is used as the compressed gas. The supplied compressed gas is supplied to the gas heater 61 and the powder supply device 63 by a valve 65 and a valve 66 respectively. The compressed gas supplied to the gas heater 61 has a temperature of, for example, 50°C or higher, and is supplied to the spray gun 63 after being heated to a temperature equal to or lower than a melting point of copper or copper alloy that is the material powder of the metal film 3. A heating temperature of the compressed gas is preferably 300°C to 900°C.

By the compressed gas supplied to the powder supply device 63, material powder with a particle diameter of, for example, about 10 µm to about 100 µm inside the powder supply device 63 is supplied to the spray gun 62 at a predetermined discharge rate. The heated compressed gas becomes a supersonic flow (about 340 m/s or faster) by the gas nozzle 64 forming a convergent-divergent shape. Moreover, the gas pressures of the compressed gas may be about 1 MPa to about 5 MPa. When the gas pressures of the compressed gas is about 1 MPa to about 5 MPa, the adhesion strength between the substrate 1 and the metal film 3 can be improved. It may be preferable to perform processing at about 2 MPa to about 4 MPa. The powder material supplied to the spray gun 62 is accelerated by injection into the supersonic flow of the compressed gas, and the solid-phase powder material collides with the substrate at high speed to form a film. Moreover, the present invention is not limited to the cold spray device 60 of FIG. 2, as long as any device capable of forming a film by colliding solid-phase material powder against the substrate 1 may also be used.

After the metal film 3 is formed on the substrate 1 by the cold spray device with the intermediate layer 2 interposed therebetween, an annealing process for heating the lamination 10 to a predetermined temperature is performed. The annealing process is preferably performed at a temperature of 300°C to 500°C. By heating the lamination 10 at a temperature of 300°C or higher, the workability can be improved by reducing the hardness of the metal film 3 formed of copper or copper alloy, and the conductivity of the lamination 10 can be improved. By performing the annealing process at a temperature of 500°C or lower, an influence according to the heating on the lamination 10 can be reduced.

Since the intermediate layer 2 for suppressing the formation of an intermetallic compound between aluminum and copper is formed of a predetermined metal or the like between the substrate 1 formed of aluminum or aluminum alloy and the copper or copper alloy metal film 3 laminated by the cold spray device 60, the lamination 10 according to an embodiment of the present invention can be annealed at a higher temperature. A degradation in the strength of the interface of the lamination 10 can be suppressed, and the workability and conductivity of the lamination 10 can be improved.

The above embodiment of the present invention has described the lamination 10 in which aluminum or aluminum is selected as the substrate 1, the intermediate layer 2 formed of any one metal or nonmetal selected from the group consisting of silver, gold, chromium, iron, germanium, manganese, nickel, silicon, and zinc, or an alloy containing the any one metal is formed on the substrate 1, and the metal film 3 formed of copper or copper alloy is formed on the surface of the intermediate layer 2 by the cold spray device 60. However, a lamination 10, in which copper or copper alloy is selected as a substrate 1, an intermediate layer 2 formed of any one metal or nonmetal selected from the group consisting of silver, gold, chromium, iron, germanium, manganese, nickel, silicon, and zinc, or an alloy containing the any one metal is formed on the substrate 1, and a metal film 3 formed of aluminum or aluminum alloy is formed on the surface of the intermediate layer 2 by the cold spray device 60, may also be similarly manufactured.

When the aluminum or aluminum alloy metal film 3 is formed on the substrate 1 formed of copper or copper alloy with the intermediate layer 2 interposed therebetween, the compressed gas used in the cold spray device 60 may be heated to a temperature of, for example, 50°C or higher, or a temperature equal to or lower than a melting point of the aluminum or aluminum alloy that is the material powder of the metal film 3, preferably 200°C to 400°C.

The lamination 10 of the present invention, in which the intermediate layer 2 for suppressing the formation of an intermetallic compound between aluminum and copper is formed of a predetermined element between the substrate 1 formed of copper or copper alloy and the aluminum or aluminum alloy metal film 3 laminated by the cold spray device 60, can be annealed at a high temperature. A degradation in the strength of the interface of the lamination 10 can be suppressed, and the workability and conductivity of the lamination 10 can be improved.

### Embodiments

### (First Embodiment)

A lamination 10 is formed by forming a silver or nickel intermediate layer 2 (thickness: 5 µm) on an aluminum substrate 1 by a plating method and forming a copper metal film 3 on a surface opposite to a surface of the intermediate layer 2 contacting the substrate 1 (compressed gas temperature: 800°C, gas pressure: 5 MPa) by the cold spray device 60. The lamination 10 is annealed in a vacuum state at 400°C for four hours, and formation of an intermetallic compound between aluminum and copper is checked. Moreover, as a comparative example, a lamination, in which a predetermined intermediate layer 2 is not formed on a substrate 1 formed of aluminum and a copper metal film 3 is formed on the surface of the substrate 1 by a cold spray device (compressed gas temperature: 800°C, gas pressure: 5 MPa), is annealed in a vacuum state at 400°C for four hours, and formation of an intermetallic compound is checked.

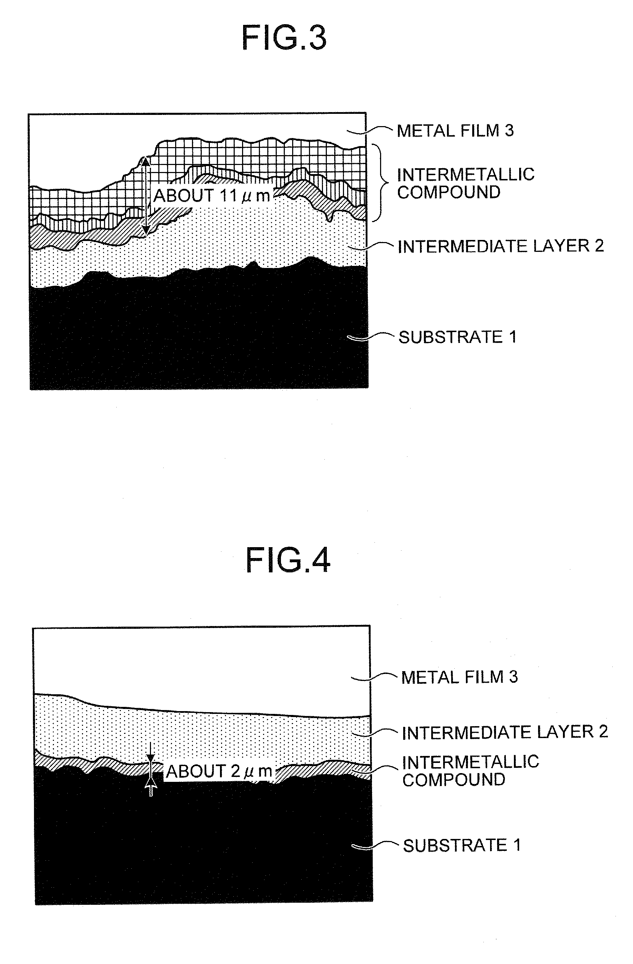

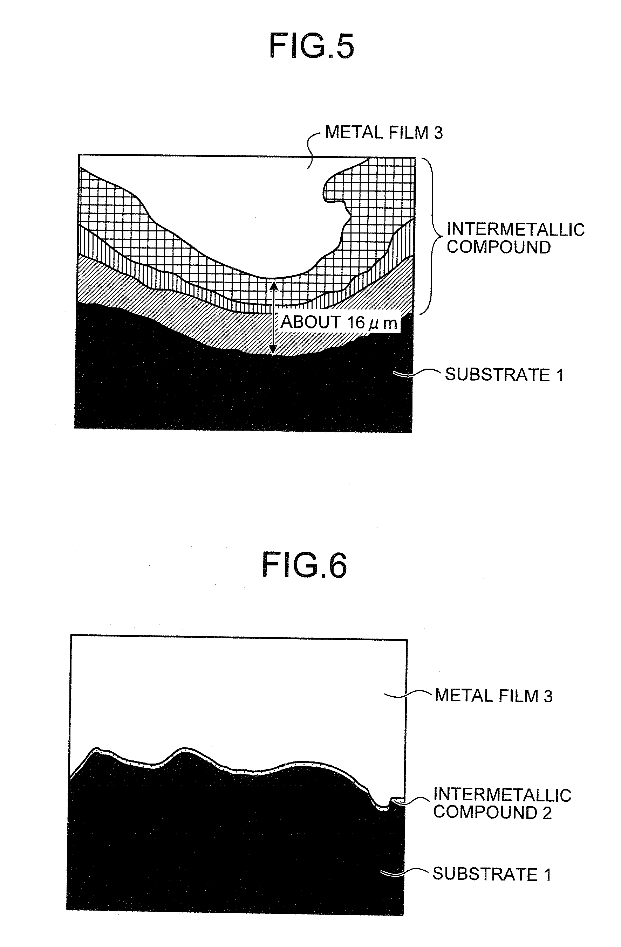

FIG. 3 is a diagram illustrating a sectional structure of the lamination 10 having the intermediate layer 2 formed of silver according to the first embodiment of the present invention. FIG. 4 is a diagram illustrating a sectional structure of the lamination 10 having the intermediate layer 2 formed of nickel according to the first embodiment of the present invention. FIG. 5 is a diagram illustrating a sectional structure of the lamination according to the comparative example.

As illustrated in FIG. 5, in the comparative example, since an intermediate layer 2 is not provided, an intermetallic compound is formed to a thickness of about 16 µm by an annealing process performed in a vacuum state at 400°C for four hours. However, in the lamination 10 having the intermediate layer 2 formed of silver to a thickness of 5 µm by a plating method, the formation of an intermetallic compound is suppressed to a thickness of about 11 µm as illustrated in FIG. 3. Moreover, in the lamination 10 having the intermediate layer 2 formed of nickel to a thickness of 5 µm by a plating method, the formation of an intermetallic compound is suppressed to a thickness of about 2 µm as illustrated in FIG. 4.

### (Second Embodiment)

A lamination 10 is formed by forming a nickel intermediate layer 2 (thickness: 2 µm) on an aluminum substrate 1 by a plating method and forming a copper metal film 3 on a surface opposite to a surface of the intermediate layer 2 contacting the substrate 1 (compressed gas temperature: 800°C, gas pressure: 5 MPa) by the cold spray device 60. The lamination 10 is retained in an atmosphere at 250°C for 300 hours, and a long-term retention test performed under an environment of using the lamination 10. Moreover, as a comparative example, a lamination, in which a predetermined intermediate layer 2 is not formed on a substrate 1 formed of aluminum and a copper metal film 3 is formed on the surface of the substrate 1 by a cold spray device (compressed gas temperature: 800°C, gas pressure: 5 MPa), is retained in an atmosphere at 250°C for 300 hours, and a long-term retention test is performed.

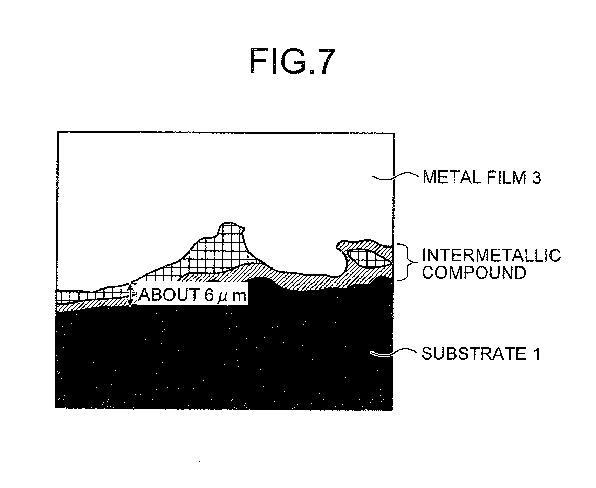

FIG. 6 is a diagram illustrating a sectional structure of the lamination 10 having the intermediate layer 2 formed of nickel according to the second embodiment of the present invention, after a long-term retention test. FIG. 7 is a diagram illustrating a sectional structure of the lamination according to the comparative example after a long-tem retention test.

As illustrated in FIG. 7, in the comparative example, an intermetallic compound with a thickness of about 6 µm is formed in a long-term retention test in an atmosphere at 250°C for 300 hours. However, in the lamination 10 having the intermediate layer 2 formed of nickel to a thickness of 2 µm by a plating method, an intermetallic compound is nearly unrecognized and the formation of an intermetallic compound is suppressed as illustrated in FIG. 6.

### Industrial Applicability

As described above, the lamination according to the present invention, the conductive material using the lamination, and the method for manufacturing the lamination are useful in manufacturing a conductive material.

### Reference Signs List

- 1: substrate
- 2: intermediate layer
- 3: metal film
- 10: lamination
- 60: cold spray device
- 61: gas heater
- 62: spray gun
- 63: powder supply device
- 64: gas nozzle

## Claims

1. A lamination comprising:
a substrate formed of aluminum or aluminum alloy;
an intermediate layer formed of any one metal or nonmetal selected from the group consisting of silver, gold, chromium, iron, germanium, manganese, nickel, silicon, and zinc, or an alloy containing the any one metal, on a surface of the substrate; and
a film layer formed by accelerating powder material of copper or copper alloy together with gas heated to a temperature lower than a melting point of the powder material and spraying and depositing a solid-phase powder material onto a surface of the intermediate layer.

2. A lamination comprising:
a substrate formed of copper or copper alloy;
an intermediate layer formed of any one metal or nonmetal selected from the group consisting of silver, gold, chromium, iron, germanium, manganese, nickel, silicon, and zinc, or an alloy containing the any one metal, on a surface of the substrate; and
a film layer formed by accelerating powder material of aluminum or aluminum alloy together with gas heated to a temperature lower than a melting point of the powder material and spraying and depositing a solid-phase powder material onto a surface of the intermediate layer.

3. The lamination according to claim 1 or 2, wherein the lamination is heated at a predetermined temperature after the formation of the film layer.

4. The lamination according to claim 3, wherein the heating temperature is 300°C to 500°C.

5. The lamination according to any one of claims 1 to 4, wherein the intermediate layer is a multi-layered lamination comprising the any one metal or nonmetal, or an alloy containing the any one metal.

6. The lamination according to any one of claims 1 to 5, wherein the intermediate layer has a thickness of 0.2 µm to 20 µm.

7. The lamination according to any one of claims 1 to 6, wherein the intermediate layer is formed by spraying, cold spraying, plating, sputtering, or CVD.

8. A conductive material comprising the lamination according to any one of claims 3 to 7.

9. A method for manufacturing a lamination, comprising the steps of:
forming an intermediate layer, which is formed of any one metal or nonmetal selected from the group consisting of silver, gold, chromium, iron, germanium, manganese, nickel, silicon, and zinc, or an alloy containing the any one metal, on a surface of a substrate formed of aluminum or aluminum alloy; and
forming a film layer by accelerating powder material of copper or copper alloy together with gas heated to a temperature lower than a melting point of the powder material and spraying and depositing a solid-phase powder material onto a surface of the intermediate layer.

10. A method for manufacturing a lamination, comprising the steps of:
forming an intermediate layer, which is formed of any one metal or nonmetal selected from the group consisting of silver, gold, chromium, iron, germanium, manganese, nickel, silicon, and zinc, or an alloy containing the any one metal, on a surface of a substrate formed of copper or copper alloy; and
forming a film layer by accelerating powder material of aluminum or aluminum alloy together with gas heated to a temperature lower than a melting point of the powder material and spraying and depositing a solid-phase powder material onto a surface of the intermediate layer.

11. The method according to claim 9 or 10, comprising the step of an annealing process for heating the lamination at a predetermined temperature after the step of forming a film layer.
